# FASCICULE DE BREVET EUROPEEN

(11) **EP 3 387 737 B1**
(45) Date de publication et mention de la délivrance du brevet: **21.04.2021**
(21) Numéro de dépôt: 16806144.8
(22) Date de dépôt: 07.12.2016
(51) Int. Cl.: H02K 1/18, H02K 3/52, H02K 11/215, H05K 1/02, H01R 12/71, H02K 11/22

(54) **MOTEUR ÉLECTRIQUE**
ELEKTROMOTOR
ELECTRIC MOTOR

(30) Priorité: 11.12.2015 FR 1562199
(43) Date de publication de la demande: 17.10.2018
(73) Titulaire: Sonceboz Automotive SA, 2605 Sonceboz (CH)
(72) Inventeur: ANDRIEUX, Gaël, 2533 Evilard (CH); PEIPPONEN, Mikko, 80803 Munich (DE); KUHN, Johannes, Konstantin, 80804 München (DE); SCHREINER, Thomas, 85609 Aschheim (DE)
(74) Mandataire: IP Trust
(86) Numéro de dépôt international: PCT/EP2016/080016
(87) Numéro de publication internationale: WO 2017/097807

(56) Documents cités:
- DE-A1- 10 149 574
- DE-A1-102004 006 575
- DE-A1-102010 039 747
- FR-A1- 3 019 951
- GB-A- 2 509 516
- US-A1- 2002 093 259

## Description

### Domaine de l'invention

La présente invention concerne le domaine de la connexion électrique de composants électriques sur un circuit imprimé, et notamment des connexions pour le passage de courants élevés, typiquement de 50 à 200 ampères, à des tensions de 12 à 72 volts.

Un exemple particulier et non limitatif d'application concerne le raccordement des bobinages d'un moteur électrique à un circuit imprimé.

### Etat de la technique

On connaît dans l'état de la technique la demande de brevet allemand DE102007032872 décrivant la réalisation d'un moteur à rotor extérieur ayant, à son stator, une pluralité de bobines d'excitation.

On connaît aussi la demande de brevet internationale WO2009062469 qui décrit un conducteur électrique, en particulier sous forme de conducteur plat d'une grille estampée. L'invention vise particulièrement à économiser du cuivre en réalisant le conducteur sous forme de matériau composite stratifié, avec une couche de cuivre sur les deux côtés de laquelle sont apposées des couches d'aluminium.

Le brevet européen EP1531522 décrit un contact de raccordement électrique. L'invention propose de former le contact de raccordement avec une zone d'impression à au moins deux couches avec au moins trois (par exemple six) branches ressort par un processus d'estampage et de matriçage, qui forment, ensemble, un ressort en forme d'étoile. La zone d'impression de l'invention améliore la liaison électrique et mécanique avec une plaque conductrice non représentée (multicouche) ou avec un grillage estampé. Le contact de raccordement est réalisé sans brasage.

Le brevet européen EP0887883 décrit un contact pour un emmanchement dans un trou métallisé d'une carte imprimée, comprenant un ressort de contact ou une fiche de contact, un élément de tige venant se raccorder dessus et une fiche de raccordement formant un prolongement de l'élément de tige central.

Le brevet américain US7377823 concerne une broche qui est enfoncée dans un trou traversant conducteur pratiqué dans une carte à circuit imprimé. La broche comporte une partie de contact, une partie d'épaulement, une partie à enfoncer et une partie d'extrémité. La partie de contact forme une borne d'un connecteur mâle à monter sur la carte à circuit imprimé par insertion dans un boîtier du connecteur mâle le long de la partie d'épaulement. Le mécanisme d'ajustage par frottement est donc réalisé par frottement dans le trou traversant, ce qui permet de fixer mécaniquement la broche à enfoncer sur la carte à circuit imprimé.

Le document DE10149574 révèle une grille estampée pour l'électricité centrale dans les véhicules automobiles ayant un contact de connexion sous la forme d'une lame recevant un contact.

Le document DE102004006575 révèle un distributeur d'électricité ayant au moins une structure de grille perforée dans laquelle des contacts sont enfoncés.

### Inconvénients de l'art antérieur

Les solutions de l'art antérieur présentent différentes solutions qui sont adaptées pour le passage de fortes puissances (plusieurs kilowatts typiquement), mais ne permettent pas le raccordement aisé d'un moteur électrique d'une part à un circuit imprimé d'autre part. Par ailleurs, les solutions de l'art antérieur ne permettent pas un mode d'assemblage adapté à un montage rapide d'un tel ensemble de connexion (moteur et circuit imprimé).

### Solution apportée par l'invention

Afin de remédier à ces inconvénients, l'invention concerne selon son acception la plus générale un moteur électrique comportant un circuit imprimé présentant un insert conducteur traversé par des trous de connexion et un ensemble bobiné présentant des liaisons électriques terminées par des fiches de connexion, comportant en outre des pièces de connexion présentant une tige dont la section transversale extérieure est complémentaire de la section desdits trous de connexion, la pièce de connexion présentant à son extrémité proximal un épaulement d'une section supérieure à la section desdits trous de connexion, l'extrémité opposée présentant une fente s'étendant jusqu'audit épaulement et présentant du coté distal une ouverture de largeur supérieure ou égale à la section desdites fiches de connexions et au moins un rétrécissement de largeur inférieure à la section desdites fiches de connexion, pour assurer une expansion du col de ladite pièce de connexion engagée dans le trou de l'insert du circuit imprimé.

Selon une variante, ladite fente s'étend au-delà dudit épaulement, en direction proximale, ladite pièce de connexion présentant au moins une gorge extérieure pour son insertion par déformation élastique dans un trou de l'insert.

Selon une autre variante, ladite pièce de connexion présente deux jambes déformables élastiquement, prolongés par un épaulement et définissant une fente présentant au moins un rétrécissement.

De préférence, les trous de connexion présentent une partie centrale délimitée par deux bords rectilignes parallèles distants d'une largeur correspondant à l'épaisseur de la pièce de connexion au niveau de l'épaulement, ladite partie centrale étant prolongée de part et d'autre par une zone élargie.

Avantageusement, lesdites zones élargies présentent des bords rectilignes parallèles distants d'une largeur correspondant à la largeur dudit col de la pièce de connexion.

Selon une variante, chacune desdites jambes présente une protubérance intérieure définissant ledit rétrécissement.

Selon une autre variante, chacune desdites jambes présente une zone de renfoncement extérieure en-dessous dudit col, chacune des jambes présentant en outre une patte de blocage s'étendant depuis l'extrémité inférieure dudit renfoncement jusqu'au niveau inférieur du col.

De préférence, ladite pièce de connexion est constituée par une superposition d'une pluralité de tôles conductrices superposées.

Selon une autre variante avantageuse, ledit ensemble bobiné est disposé à l'intérieur d'un rotor tubulaire, ledit ensemble bobiné étant formé de bobines portées par des dents constituées par un paquet de tôles ferromagnétiques, lesdites dents s'étendant radialement par rapport à un noyau tubulaire ferromagnétique entourant un cœur en un matériau conducteur thermiquement présentant une première section en contact avec le boîtier et une deuxième section de rayon moindre en contact avec ledit noyau tubulaire du moteur, ledit cœur étant en contact avec le boîtier extérieur du moteur pour assurer l'évacuation de la chaleur produit par les bobines.

Selon une autre variante, les pièces ferromagnétiques sont constituées de matière magnétique frittée ou injectée, ou d'une combinaison de paquets de tôles et de telles matières.

Avantageusement, ledit matériau conducteur thermiquement présente une forme de « T ».

De préférence, ledit cœur présente un évidemment traversant pour le passage d'un axe solidaire dudit rotor tubulaire extérieure et entraînant un aimant disposé au voisinage d'une sonde de détection fixée sur ledit circuit imprimé positionné dans le prolongement dudit cœur.

Selon une variante, l'aimant est disposé dans une cavité de l'axe ou d'une pièce additionnelle, les parois de cette cavité servant de blindage électromagnétique.

Selon une variante, ladite sonde de détection est positionnée dans l'axe dudit coeur.

Selon un mode de réalisation particulier, ledit évidemment du cœur présente au moins un roulement pour le guidage dudit axe du rotor tubulaire.

Selon un autre mode de réalisation, le rotor comprend une face transversale présentant au moins une lumière traversante pour assurer une circulation d'air vers l'ensemble bobiné.

Avantageusement, lesdites lumières sont configurées pour assurer un forçage de l'air circulant lors de la rotation du rotor.

Selon une autre variante, l'ensemble rotatif comporte une protubérance ferromagnétique formant un blindage dans le voisinage de la sonde de détection.

L'invention concerne aussi un ensemble de connexion constitué par un circuit imprimé présentant un insert conducteur traversé par des trous de connexion et une pluralité de liaisons électriques terminées par des fiches de connexion complémentaires, comportant en outre des pièces de connexion (1) présentant une tige dont la section transversale extérieure est complémentaire de la section desdits trous de connexion, la pièce de connexion présentant à son extrémité proximal un épaulement d'une section supérieure à la section desdits trous de connexion, l'extrémité opposée présentant une fente s'étendant jusqu'audit épaulement et présentant du côté distal une ouverture de largeur supérieure ou égale à la section desdites fiches de connexions et au moins un rétrécissement de largeur inférieure à la section desdites fiches de connexion, pour assurer une expansion du col de ladite pièce de connexion engagée dans le trou de l'insert du circuit imprimé.

### Description détaillée d'un exemple

### non limitatif de réalisation

La présente invention sera mieux comprise à la lecture de la description qui suit, se référant aux dessins annexés où :
- la figure 1 représente une vue en coupe d'un ensemble de connexion selon l'invention ;
- la figure 2 représente une vue en coupe transversale d'un ensemble de connexion selon l'invention, dans le plan de l'insert ;
- la figure 3 représente une vue en coupe d'une variante de réalisation d'une pièce de connexion ;
- la figure 4 représente une vue en coupe d'un moteur à rotor extérieur selon l'invention ;
- la figure 5 représente une vue de trois-quart inférieur du moteur selon l'invention.

### Structure du système de connexion

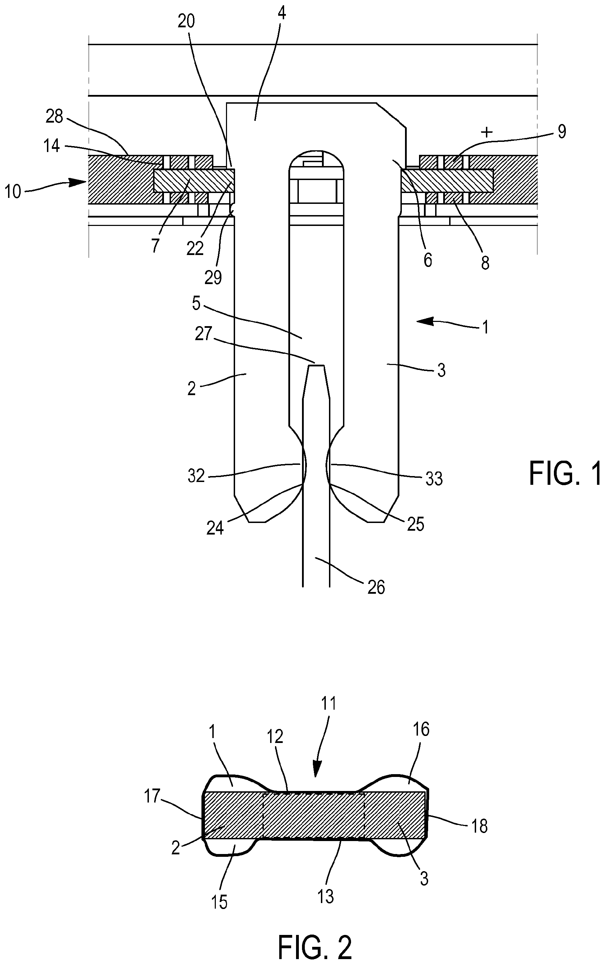

La figure 1 représente un exemple de réalisation d'une pièce de connexion (1) présentant deux jambes (2, 3) parallèles reliées par une tête (4).

Le système de connexion comprend plusieurs pièces de connexion (1) et un circuit imprimé (10) présentant des inserts métalliques (7) complémentaires.

Les deux jambes (2, 3) définissent entre elles une fente (5) s'étendant jusqu'au niveau d'un col (6). La pièce de connexion (1) est constituée par un empilement de tôles découpées.

La pièce (1) vient se loger dans un insert (7) métallique placé entre deux couches isolantes (8, 9) pour former un circuit imprimé comportant par ailleurs de façon connue des pistes conductrices (28) à la surface d'une des couches isolantes au moins.

L'insert (7) présente une découpe oblongue (11) dont la figure 2 représente une vue agrandie.

La découpe (11) présente une zone centrale délimitée par deux bords rectilignes (12, 13) parallèles venant en contact avec les surfaces latérales de la tête (4) de la pièce de connexion (1). Cette zone centrale est prolongée de part et d'autre par des excroissances (15, 16) de plus grande largeur, présentant chacune un bord (17, 18) de forme complémentaire à l'arête des jambes respectivement (2, 3), au niveau du col (6) de la pièce de connexion (1).

Les zones de contact électriques entre la pièce de connexion (1) et l'insert (7) correspondent aux bords (12, 13 et 17, 18). L'insert (7) présente une épaisseur d'environ 1 millimètre, et de préférence entre 0,5 et 2 millimètres, ce qui garantit une surface de contact suffisante pour passer des puissances électriques élevées, de 10KW par exemple pour un courant de 200 ampères sous une tension de 48 volts.

Les zones élargies (15, 16) permettent un basculement de la pièce de connexion (1), ce qui assure une tolérance géométrique lors de l'assemblage du système de connexion.

L'insert (7) présente dans l'exemple décrit une nervure (22) assurant une flexibilité facilitant l'insertion du col (6) de la pièce de connexion.

La pièce de connexion (1) présente un épaulement (20) limitant le déplacement de la pièce de connexion (1) lors de son insertion dans le circuit imprimé.

Les jambes (2, 3) présentent chacune une protubérance (32, 33) dirigée vers l'intérieur de la fente (5) afin de réduire localement la largeur de la fente (5). L'extrémité distale de la fente (5) est évasée grâce à des chanfreins et/ou des rayons (24, 25) prévus à la surface intérieure de l'extrémité des jambes respectivement (2, 3).

La partie complémentaire à raccorder comprend une fiche de connexion (26) formée par une lame plane, par exemple en laiton ou en cuivre, dont l'extrémité (27) présente une forme de pointe. Lors de son insertion dans la fente (5) d'une pièce de connexion (1), elle provoque l'écartement des jambes (2, 3) lorsque l'extrémité (27) rencontre les protubérances (32, 33). Cet écartement se traduit par une légère expansion transversale de la pièce (1) au niveau du col (6), ce qui renforce le contact entre la bordure périphérique de la pièce (1) au niveau de son col (6), et les bords (17, 18) de la découpe de l'insert. L'élasticité des jambes (2, 3) permet de contrôler la force d'appui du col (6) sur les bords de la découpe (11) de l'insert (7).

Dans l'exemple décrit en figure 1, la pièce (1) présente un deuxième épaulement (29) définissant, avec le premier épaulement (20) le col.

Le deuxième épaulement (29) est de section légèrement supérieure à la section de la découpe (11) de l'insert (7). Il peut néanmoins passer en force en raison de l'élasticité de la nervure (22) prévue sur les bords de la découpe de l'insert (7) et de la flexibilité de la pièce de connexion (1).

Le fonctionnement de ce premier exemple de réalisation est le suivant :
On prépare le circuit imprimé avec ses inserts (7) découpés. Les inserts (7) sont reliés électriquement à des pistes conductrices (28) du circuit imprimé par des connexions électriques (14).

On introduit ensuite les pièces de connexions (1) dans les découpes des inserts (7) en les pressant contre la surface supérieure du circuit imprimé ou de l'insert. La flexibilité des inserts permet le passage en force du deuxième épaulement (29) jusqu'à ce que le premier épaulement (20) vienne en contact avec la surface supérieure de l'insert (7).

On presse ensuite le circuit imprimé équipé des pièces de connexion contre l'équipement complémentaire, présentant des fiches de connexion (26) dirigées en direction du circuit imprimé. Les éventuels désalignements sont possibles en raison de la mobilité en basculement des pièces de connexion (1), ce qui autorise une tolérance d'alignement.

En pressant l'équipement muni des fiches (26) contre le circuit imprimé, les fiches (26) s'insèrent dans les fentes (5) des pièces de connexion en vis-à-vis, ce qui provoque l'écartement des jambes (2, 3) et l'expansion de la pièce de connexion (1) au niveau du col (6), et donc le renforcement du contact mécanique et électrique entre le col (6) de la pièce de connexion (1) et l'insert (7).

### Structure d'un moteur comprenant un tel système de connexion

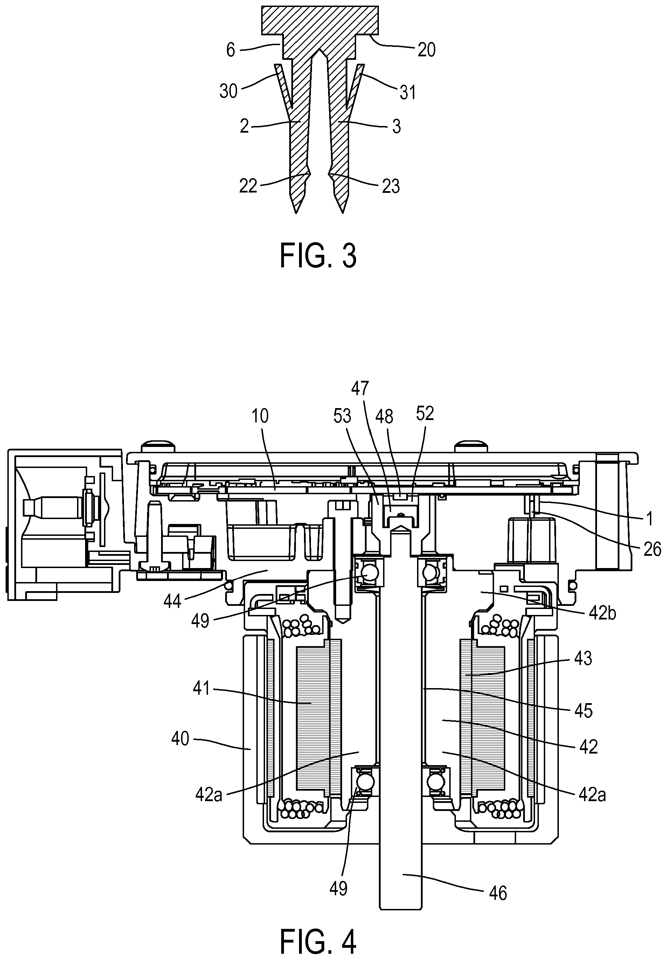

La figure 4 représente un exemple de moteur à rotor (40) extérieur mettant en œuvre un tel système de connexion.

Le stator est constitué par un stator bobiné (41) monté sur un cœur (42). Les bobines sont alimentées par des conducteurs terminés par des fiches de connexion (26) venant s'insérer dans des pièces de connexion (1) montés sur un circuit imprimé (10). L'avantage de ce système de connexion est qu'il permet de réaliser industriellement la partie basse du moteur, comprenant le rotor extérieur (40) et le stator bobiné d'une part, et la partie haute comprenant les parties électronique d'autre part, puis d'assembler par un simple assemblage mécanique consistant à presser les deux parties l'une contre l'autre, afin d'assurer à la fois l'assemblage mécanique et électrique.

Le stator présente un cœur (42) assurant à la fois la tenue mécanique du stator bobiné (41), et aussi l'évacuation de la puissance dissipée dans ledit stator bobiné. Dans le cas d'un moteur à rotor extérieur, la chaleur produite par l'ensemble bobiné (41) est difficile à évacuer car confinée à l'intérieur du moteur. L'invention concerne un cœur (42) présentant une première section (42a) entourée par le stator bobiné (41), prolongée par une deuxième section (42b) de diamètre supérieur, de forme tronconique. Le cœur (42) présente ainsi une section globalement en forme de « T ». La deuxième section (42b) est en contact avec le boîtier métallique (44). Cette architecture permet d'améliorer la transmission de chaleur dégagée par les bobines du moteur et les pertes fer pour l'évacuer vers le boîtier (44) métallique. Le cœur (42) présente un évidemment (45) axial qui est traversé par un axe (46) solidaire du rotor (40) extérieur. Il entraîne un aimant (47) disposé au voisinage d'une sonde de détection (48) fixée sur ledit circuit imprimé positionné dans le prolongement du cœur (42). La sonde de détection (48) est positionnée dans l'axe du cœur (42). L'évidemment présente un roulement (49) pour le guidage de l'axe du rotor tubulaire.

L'aimant (47) est disposé dans une cavité (52), les parois de ladite cavité assurant un blindage autour de la sonde de détection (48).

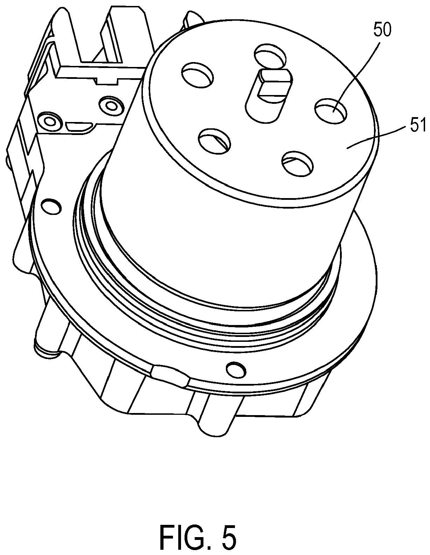

La figure 5 représente une vue de dessous du moteur. Le rotor comprend une face transversale (51) présentant au moins une lumière (50) traversant pour assurer une circulation d'air vers l'ensemble bobiné (41). Ces lumières (50) sont configurées pour assurer une circulation de l'air lors de la rotation du rotor et peuvent être à perçage droit (comme illustré) ou incliné (non montré) pour permettre une circulation forcée.

La figure 3 présente une réalisation alternative de la pièce de connexion (1) qui présente avantageusement des pattes de blocage (30, 31) pour éventuellement éviter la sortie de la pièce de connexion (1) lors de l'insertion des fiches de connexion électriques.

## Revendications

1. Ensemble de connexion constitué par un circuit imprimé présentant un insert (7) conducteur traversé par des trous de connexion et une pluralité de liaisons électriques terminées par des fiches de connexion (26) complémentaires comportant en outre des pièces de connexion présentant une tige dont la section transversale extérieure est complémentaire de la section desdits trous de connexion, chacune des pièces de connexion (1) présentant à son extrémité proximal un épaulement (20) d'une section supérieure à la section desdits trous de connexion, l'extrémité distale présentant une fente (5) s'étendant jusque à un col, qui est inséré dans ledit trou de connexion, et jusqu'audit épaulement et présentant du côté distal une ouverture de largeur supérieure ou égale à la section desdites fiches de connexion (26) et au moins un rétrécissement de largeur inférieure à la section desdites fiches de connexion (26), pour assurer une expansion du col de ladite pièce de connexion (1) engagée dans le trou de l'insert du circuit imprimé.

2. Moteur électrique comportant un ensemble de connexion selon la revendication 1 présentant un insert (7) conducteur traversé par des trous de connexion et un ensemble bobiné (41) présentant des liaisons électriques terminées par des fiches de connexion (26) **caractérisé en ce qu'**il comporte en outre des pièces de connexion (1) présentant une tige dont la section transversale extérieure est complémentaire de la section desdits trous de connexion, la pièce de connexion (1) présentant à son extrémité proximale un épaulement (20) d'une section supérieure à la section desdits trous de connexion, l'extrémité distal présentant une fente (5) s'étendant jusqu'audit épaulement et présentant du côté distal une ouverture de largeur supérieure ou égale à la section desdites fiches de connexion (26) et au moins un rétrécissement de largeur inférieure à la section desdites fiches de connexion (26), pour assurer une expansion du col de ladite pièce de connexion (1) engagée dans le trou de l'insert du circuit imprimé.

3. Moteur électrique selon la revendication 2 **caractérisé en ce que** ladite fente (5) s'étend au-delà dudit épaulement, en direction proximale, ladite pièce de connexion (1) présentant au moins une gorge extérieure pour son insertion par déformation élastique dans un trou de l'insert.

4. Moteur électrique selon la revendication 2 **caractérisé en ce que** ladite pièce de connexion (1) présente deux jambes (2, 3) déformables élastiquement, prolongées par un épaulement (20) et définissant une fente (5) présentant au moins un rétrécissement.

5. Moteur électrique selon l'une au moins des revendications précédentes **caractérisé en ce que** les trous de connexion présentent une partie centrale délimitée par deux bords rectilignes (12, 13) parallèles distant d'une largeur correspondant à l'épaisseur de la pièce de connexion (1) au niveau de l'épaulement, ladite partie centrale étant prolongée de part et d'autre par une zone élargie.

6. Moteur électrique selon la revendication précédente **caractérisé en ce que** lesdites zones élargies présentent des bords (17, 18) distant d'une largeur correspondant à la largeur dudit col de la pièce de connexion (1).

7. Moteur électrique selon la revendication 4 **caractérisé en ce que** chacune desdites jambes (2, 3) présente une protubérance intérieure (22, 23, 32, 33) définissant ledit rétrécissement.

8. Moteur électrique selon l'une au moins des revendications précédentes **caractérisé en ce que** chacune desdites jambes présente une zone de renfoncement extérieure en-dessous dudit col, chacune des jambes (2, 3) présentant en outre une patte de blocage (30, 31) s'étendant depuis l'extrémité inférieure dudit renfoncement jusqu'au niveau inférieur du col.

9. Moteur électrique selon l'une au moins des revendications précédentes **caractérisé en ce que** ladite pièce de connexion (1) est constituée par une superposition d'une pluralité de tôles conductrices superposées.

10. Moteur électrique selon l'une au moins des revendications précédentes **caractérisé en ce que** ledit ensemble bobiné est disposé à l'intérieur d'un rotor (40) tubulaire, ledit ensemble bobiné étant formé de bobines portées par des dents constituées par un paquet de tôles ferromagnétiques, lesdites dents s'étendant radialement par rapport à un noyau (43) tubulaire ferromagnétique entourant un cœur en un matériau conducteur thermiquement présentant une première section (42b) en contact avec le boîtier (44) et une deuxième section (42a) de rayon moindre en contact avec ledit noyau tubulaire du moteur, ledit cœur étant en contact avec le boîtier extérieur (44) du moteur pour assurer l'évacuation de la chaleur produite par les bobines.

11. Moteur électrique selon la revendication précédente **caractérisé en ce que** ledit matériau conducteur thermiquement présente une forme de « T ».

12. Moteur électrique selon la revendication précédente **caractérisé en ce que** ledit cœur présente un évidemment (45) traversant pour le passage d'un axe (46) solidaire dudit rotor tubulaire extérieure et entraînant un aimant (47) disposé au voisinage d'une sonde de détection (48) fixée sur ledit circuit imprimé positionné dans le prolongement dudit cœur.

13. Moteur électrique selon la revendication précédente **caractérisé en ce que** ladite sonde de détection (48) est positionnée dans l'axe dudit coeur.

14. Moteur électrique selon la revendication 12 **caractérisé en ce que** ledit évidemment du cœur présente au moins un roulement (49) pour le guidage dudit axe du rotor tubulaire.

15. Moteur électrique selon la revendication 12 **caractérisé en ce que** le rotor comprend une face transversale (51) présentant au moins une lumière (50) traversante pour assurer une circulation d'air vers l'ensemble bobiné.

16. Moteur électrique selon la revendication précédente **caractérisé en ce que** lesdites lumières (50) sont configurées pour assurer un forçage de l'air circulant lors de la rotation du rotor.

17. Moteur électrique selon la revendication 12 **caractérisé en ce que** l'ensemble rotatif comporte une protubérance ferromagnétique (53) formant un blindage dans le voisinage de la sonde de détection (48).

## Patentansprüche

1. Verbindungsanordnung, bestehend aus einer gedruckten Schaltung mit einem leitenden Einsatz (7), der von Verbindungslöchern durchdrungen ist, und mehreren elektrischen Verbindungen, die an ihren Enden komplementären Verbindungsstifte (26) aufweisen, ferner umfassend Verbindungsstücke mit einem Schaft, dessen äußerer Querschnitt zu dem Querschnitt der Verbindungslöcher komplementär ist, wobei jedes der Verbindungsstücke (1) an seinem proximalen Ende eine Schulter (20) mit einem Querschnitt aufweist, der größer als der Querschnitt der Verbindungslöcher ist, wobei das distale Ende einen Schlitz (5) aufweist, der sich bis zu einem Kragen, der in das Verbindungsloch eingeführt wird, und bis zu der Schulter erstreckt und auf der distalen Seite eine Öffnung mit einer Breite größer oder gleich dem Querschnitt des Verbindungsstifts (26) und mindestens eine Verengung mit einer Breite kleiner als der Querschnitt der Verbindungsstift (26) aufweist, um eine Ausdehnung des Kragens des Verbindungsstücks (1) zu gewährleisten, der in das Loch des Einsatzes der gedruckten Schaltung eingreift.

2. Elektromotor, umfassend eine Verbindungsanordnung nach Anspruch 1 mit einem leitenden Einsatz (7), der von Verbindungslöchern durchdrungen ist, und einer gewickelten Anordnung (41) mit elektrischen Verbindungen, die an ihrem Ende Verbindungsstifte (26) aufweisen, **dadurch gekennzeichnet, dass** er ferner Verbindungsstücke (1) mit einem Schaft umfasst, deren äußerer Querschnitt zu dem Querschnitt der Verbindungslöcher komplementär ist, wobei das Verbindungsstück (1) an seinem proximalen Ende eine Schulter (20) mit einem Querschnitts aufweist, der größer als der Querschnitt der Verbindungslöcher ist, wobei das distale Ende einen Schlitz (5) aufweist, der sich bis zu der Schulter erstreckt und auf der distalen Seite eine Öffnung mit einer Breite größer oder gleich dem Querschnitt der Verbindungsstifte (26) und mindestens eine Verengung mit einer Breite kleiner als der Querschnitt der Verbindungsstift (26) aufweist, um eine Ausdehnung des Kragens des Verbindungsstücks (1) zu gewährleisten, der in das Loch des Einsatzes der gedruckten Schaltung eingreift.

3. Elektromotor nach Anspruch 2, **dadurch gekennzeichnet, dass** sich der Schlitz (5) in proximaler Richtung über die Schulter hinaus erstreckt, wobei das Verbindungsstück (1) mindestens eine äußere Nut aufweist, um durch elastische Verformung in ein Loch des Einsatzes eingesetzt zu werden.

4. Elektromotor nach Anspruch 2, **dadurch gekennzeichnet, dass** das Verbindungsstück (1) zwei elastisch verformbare Schenkel (2, 3) aufweist, die durch eine Schulter (20) verlängert sind und einen Schlitz (5) mit mindestens einer Verengung definieren.

5. Elektromotor nach mindestens einem der vorhergehenden Ansprüche, **dadurch gekennzeichnet, dass** die Verbindungslöcher einen mittleren Teil aufweisen, der durch zwei parallele geradlinige Kanten (12, 13) begrenzt ist, die mit einer Breite voneinander beabstandet sind, die der Dicke des Verbindungsstücks (1) auf der Ebene der Schulter entspricht, wobei der mittlere Teil zu beiden Seiten durch eine verbreiterte Zone verlängert ist.

6. Elektromotor nach dem vorhergehenden Anspruch, **dadurch gekennzeichnet, dass** die verbreiterten Zonen Kanten (17, 18) aufweisen, die mit einer Breite voneinander beabstandet sind, die der Breite des Kragens des Verbindungsstücks (1) entspricht.

7. Elektromotor nach Anspruch 4, **dadurch gekennzeichnet, dass** jeder der Schenkel (2, 3) eine innere Ausstülpung (22, 23, 32, 33) aufweist, die die Verengung definiert.

8. Elektromotor nach mindestens einem der vorhergehenden Ansprüche, **dadurch gekennzeichnet, dass** jeder der Schenkel eine äußere Verstärkungszone unterhalb des Kragens aufweist, wobei jeder der Schenkel (2, 3) auch eine Sperrzunge (30, 31) aufweist, die sich von dem unteren Ende der Verstärkung bis zur unteren Ebene des Kragens erstreckt.

9. Elektromotor nach mindestens einem der vorhergehenden Ansprüche, **dadurch gekennzeichnet, dass** das Verbindungsstück (1) durch Übereinanderlegen mehrerer übereinandergelegter leitfähiger Bleche gebildet ist.

10. Elektromotor nach mindestens einem der vorhergehenden Ansprüche, **dadurch gekennzeichnet, dass** die gewickelte Anordnung in einem rohrförmigen Rotor (40) angeordnet ist, wobei die gewickelte Anordnung aus Spulen besteht, die von Zähnen getragen sind, die durch ein Bündel von ferromagnetischen Blechen gebildet sind, wobei sich die Zähne radial in Bezug auf einen ferromagnetischen rohrförmigen Kern (43) erstrecken, der einen Kern aus einem wärmeleitenden Material umgibt, der einen ersten Abschnitt (42b) in Kontakt mit dem Gehäuse (44) und einen zweiten Abschnitt (42a) mit einem kleineren Radius in Kontakt mit dem rohrförmigen Kern des Motors aufweist, wobei der Kern mit dem Außengehäuse (44) des Motors in Kontakt steht, um die Ableitung der von den Spulen erzeugten Wärme sicherzustellen.

11. Elektromotor nach dem vorhergehenden Anspruch, **dadurch gekennzeichnet, dass** das wärmeleitende Material eine "T"-Form aufweist.

12. Elektromotor nach dem vorhergehenden Anspruch, **dadurch gekennzeichnet, dass** der Kern eine hindurchgehende Aussparung (45) zum Hindurchführen einer Welle (46) aufweist, die mit dem äußeren rohrförmigen Rotor einstückig ausgebildet ist und einen Magneten (47) antreibt, der in der Nähe eines Erfassungssensor (48) angeordnet ist, der an der gedruckten Schaltung befestigt ist, die in der Verlängerung des Kerns positioniert ist.

13. Elektromotor nach dem vorhergehenden Anspruch, **dadurch gekennzeichnet, dass** der Erfassungssensor (48) in der Welle des Kerns positioniert ist.

14. Elektromotor nach Anspruch 12, **dadurch gekennzeichnet, dass** die Aussparung des Kerns mindestens ein Wälzlager (49) zum Führen der Welle des rohrförmigen Rotors aufweist.

15. Elektromotor nach Anspruch 12, **dadurch gekennzeichnet, dass** der Rotor eine Querfläche (51) umfasst, die mindestens ein Durchgangsloch (50) aufweist, um eine Luftzirkulation in Richtung zur gewickelten Anordnung sicherzustellen.

16. Elektromotor nach dem vorhergehenden Anspruch, **dadurch gekennzeichnet, dass** die Durchgangslöcher (50) konfiguriert sind, um ein Beförderung der Luft, die während der Drehung des Rotors zirkuliert, sicherzustellen.

17. Elektromotor nach Anspruch 12, **dadurch gekennzeichnet, dass** die Drehanordnung eine ferromagnetische Ausstülpung (53) aufweist, die in der Nähe des Erfassungssensors (48) eine Abschirmung bildet.

## Claims

1. Connection assembly consisting of a printed circuit board, having a conductive insert (7), which is passed through by connection holes, and a plurality of electrical connections, which are terminated by complementary connection plugs (26), further comprising connection parts having a rod, of which the outer cross section is complementary to the section of said connection holes, each of the connection parts (1) having, at the proximal end thereof, a shoulder (20) with a section which is greater than the section of said connection holes, the distal end having a slot (5) extending as far as a neck, which is inserted into said connection hole, and as far as said shoulder and having, on the distal side, an opening with a width which is greater than or equal to the section of said connection plugs (26) and at least a narrowing of width which is less than the section of said connection plugs (26), in order to ensure an expansion of the neck of said connection part (1) which is engaged in the hole of the insert of the printed circuit board.

2. Electric motor, comprising a connection assembly according to claim 1 having a conductive insert (7), which is passed through by connection holes, and a coiled assembly (41) having electrical connections, which are terminated by connection plugs (26), **characterized in that** it further comprises connection parts (1) having a rod, of which the outer cross section is complementary to the section of said connection holes, the connection part (1) having, at its proximal end, a shoulder (20) with an upper section which is greater than the section of said connection holes, the distal end having a slot (5) extending as far as said shoulder and having, on the distal side, an opening with a width which is greater than or equal to the section of said connection plugs (26) and at least a narrowing of width which is less than the section of said connection plugs (26), in order to ensure an expansion of the neck of said connection part (1) which is engaged in the hole of the insert of the printed circuit board.

3. Electric motor according to claim 2, **characterized in that** said slot (5) extends beyond said shoulder, in the proximal direction, said connection part (1) having at least one outer groove for the insertion thereof into a hole of the insert by means of elastic deformation.

4. Electric motor according to claim 2, **characterized in that** said connection part (1) has two elastically deformable legs (2, 3) which are extended by a shoulder (20) and define a slot (5) having at least one narrowing.

5. Electric motor according to at least one of the preceding claims, **characterized in that** the connection holes have a central part which is delimited by two parallel rectilinear edges (12, 13) which are spaced apart by a width which corresponds to the thickness of the connection part (1) at the shoulder, said central part being extended on either side by a widened region.

6. Electric motor according to the preceding claim, **characterized in that** said widened regions have edges (17, 18) which are spaced apart by a width which corresponds to the width of said neck of the connection part (1).

7. Electric motor according to claim 4, **characterized in that** each of said legs (2, 3) has an internal projection (22, 23, 32, 33) which defines said narrowing.

8. Electric motor according to at least one of the preceding claims, **characterized in that** each of said legs has an outer indentation region below said neck, each of the legs (2, 3) also having a locking tab (30, 31) which extends from the lower end of said indentation as far as the lower level of the neck.

9. Electric motor according to at least one of the preceding claims, **characterized in that** said connection part (1) is formed by a stack of a plurality of stacked conductive sheets.

10. Electric motor according to at least one of the preceding claims, **characterized in that** said coiled assembly is arranged inside a tubular rotor (40), said coiled assembly being formed by coils which are supported by teeth consisting of a bundle of ferromagnetic sheets, said teeth extending radially with respect to a ferromagnetic tubular core (43) which surrounds a center made of a thermally conductive material having a first section (42b) in contact with the casing (44) and a second section (42a) of which the radius is less in contact with said tubular core of the motor, said center being in contact with the outer casing (44) of the motor to ensure the removal of the heat produced by the coils.

11. Electric motor according to the preceding claim, **characterized in that** said thermally conductive material has a "T" shape.

12. Electric motor according to the preceding claim, **characterized in that** said center has a recess (45) which passes therethrough for the passage of a shaft (46) which is integral with said outer tubular rotor and drives a magnet (47) arranged in the vicinity of a detection probe (48) which is fixed on said printed circuit board positioned in the extension of said heart.

13. Electric motor according to the preceding claim, **characterized in that** said detection probe (48) is positioned in the shaft of said center.

14. Electric motor according to claim 12, **characterized in that** said recess of the center has at least one bearing (49) for guiding said shaft of the tubular rotor.

15. Electric motor according to claim 12, **characterized in that** the rotor comprises a transverse face (51) having at least one opening (50) which passes therethrough to ensure circulation of air toward the coil assembly.

16. Electric motor according to the preceding claim, **characterized in that** said openings (50) are configured to ensure that the air is forced to circulate during the rotation of the rotor.

17. Electric motor according to claim 12, **characterized in that** the rotary assembly comprises a ferromanetic projection (53) which forms a shield in the vicinity of the detection probe (48).
